# EUROPEAN PATENT APPLICATION

(11) **EP 2 797 215 A1**
(43) Date of publication of application: **29.10.2014**
(21) Application number: 12859323.3
(22) Date of filing: 13.04.2012
(51) Int. Cl.: H02M 1/088, H03K 17/567

(54) **METHOD FOR OPTIMIZING VOLTAGE SELF-ADAPTATION CONTROL BASED ON IGBT SERIES LOSS**

(30) Priority: 19.12.2011 CN 201110426588
(71) Applicant: State Grid Corporation of China (SGCC), Beijing 100031 (CN); State Grid Smart Grid Research Institute, Beijing 102211 (CN); China Electric Power Research Institute, Beijing 100192 (CN)
(72) Inventor: WEN, Jialiang, Beijing 100192 (CN); CHEN, Zhongyuan, Beijing 100192 (CN); HAN, Jian, Beijing 100192 (CN); WU, Rui, Beijing 100192 (CN); WEI, Quanqing, Beijing 100192 (CN); JIA, Na, Beijing 100192 (CN); PANG, Yugang, Beijing 100192 (CN)
(74) Representative: Windal-Vercasson, Gaelle I.M.
(86) International application number: PCT/CN2012/074005
(87) International publication number: WO 2013/091326

(57) **Abstract**

A method for optimizing voltage self-adaption control based on IGBT series loss. The method comprises the following steps: (1) detecting a voltage at an IGBT end; (2) adjusting a main switching stage time; and (3) adjusting a preliminary switching stage time. By means of the method, when the IGBTs are connected in series, the voltage balance degree is improved, the switching loss is reduced, and the switching voltage stress is controllable.

## Description

### FIELD OF THE INVENTION

The invention relates to the electric power system filed, and more particularly to an adaptive voltage control method based on series IGBT loss optimization.

### BACKGROUND OF THE INVENTION

IGBT (Insulated Gate Biploar Transistor) is a composite semiconductor power switch device science the mid of 1980s, input control part of which is the MOSFET, and the output is a bipolar junction transistor. It has the advantages of both MOSEFET and power transistors: high input impedance, voltage control, small drive power, fast switching, low saturation voltage, high voltage and current capacity, wider safe work range, and the its work frequency can be up to 10-40kHz. But the disadvantage is the voltage and current permissible values of one single IGBT are hard to improve. Considering the application of the high voltage and high power fields, the IGBTs is usually in series connected module.

With the gradual popularization and application of the electronic power technology in power system, the high voltage valve, which is based on the voltage-sharing of the series connected IGBTs technique, is becoming the core component of a variety of new power electronic device like VSC-HVDC, STATCOM, UPFC etc.. in these cases, the unbalance voltage will easy to happen to the series connected IGBTs due to the higher working frequency of IGBT devices and faster switching speed. In the high voltage and large power application, the IGBTs will inevitably lead to failure or even damage once the unbalance happens. And if the series connected IGBTs happen are out of work, it will damage the power electronic devices and result in serious economic losses.

At present the IGBT voltage balance control has the load side control and the grid side control two categories. The load side control balances the series voltage mainly by parallel connecting a snubber circuit at the ends of the collector and the emitter. But its volume and loss are both great, and the reliability is poor if only using the snubber to balance the voltage. So the grid side control method becomes the main method to balance IGBT voltages. But it will lead to IGBT switching loss increase inevitably when balancing the IGBT series voltages, which will greatly reduce their work efficiency for the high power electronic devices.

The present invention is to provide an adaptive voltage control method based on series IGBT loss optimization, to improve the IGBT switching speed, reduce the switching loss of IGBT in the premise of ensuring the IGBT series voltage balancing. It proposes a new technology method for the practical application of the IGBT series.

### SUMMARY OF THE INVENTION

The IGBT balance the control principle provided by the present invention is to let the series IGBT quickly follow the reference voltage waveform, to ensure that the voltage balance of series IGBT.

The present invention provides an adaptive voltage control method based on series IGBT loss optimization, said method includes steps as below:
(1) Detecting IGBT terminal voltage;
(2) Adjusting the time of the main on/off stage;
(3) Adjusting the time of the pre-on/off stage.

Wherein said main adjustment on/off stage includes main opening stage and adjusting main shutoff stage; said pre-on/off stage includes opening pre adjustment stage and shutoff pre adjustment stage.

In said main adjustment on/off stage, each IGBT is controlled independently by their own drive circuit; the control signals of the drive circuit of IGBT are provided by the same valve base control unit.

Said the adjust time of the main on/off stage in step (2) includes below two steps:
(2-1) Detecting the IGBT terminal voltage through said step (1), comparing the dv/dt value of IGBT on/off to that of reference voltage provided by the valve base control unit, and judging the difference between them, and sending the increase or decrease signal of dv/dt to the higher level, and then valve base control unit adjusting dv/dt of the reference voltage according to the received signal from the drive unit;
(2-2) Detecting the IGBT terminal voltage through said step (1), comparing the dv/dt value of IGBT on/off to that of reference voltage provided by the valve base control unit, and determining to increase or decrease the dv/dt, and sending the signal to the lower level to balance IGBT voltage.

Said adjusting the time of the pre-on/off stage in said step (3) is carried out at each drive unit, and each IGBT is independent separately, the drive unit detects the waveform of *Vout,* and compares the actual delay time of IGBT to the pre-on/off time given by the reference voltage to determine to increase or decrease the given time of the pre-on/off of the reference voltage.

Said adjustments of pre-on/off and main on/off stage are independent with each other.

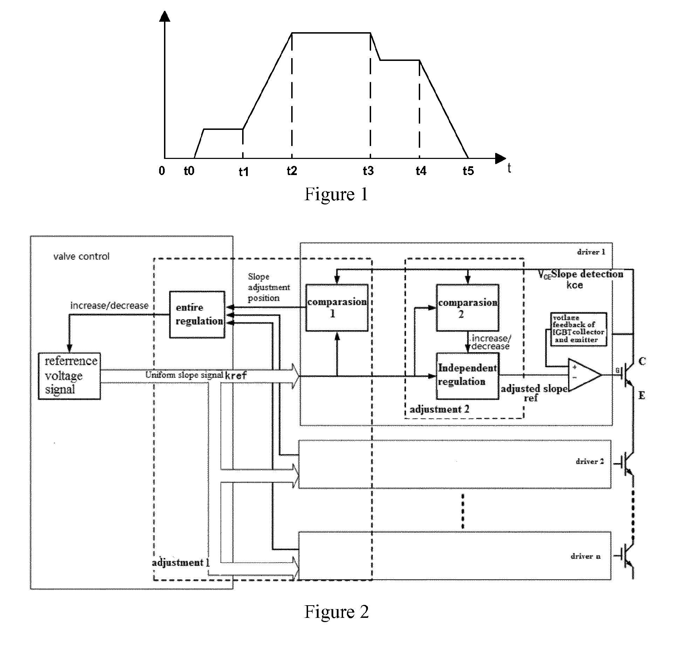

The reference voltage waveform is shown as figure 1. It mainly contains pre-off stage (t0-t1), main off stage (t1-t2), pre-on on stage (t3-t4) and main on stage (t4-t5). The pre-off stage and pre-on stage have the same control principle, and so do main off stage and main on stage.

When the pre off stage and main off stage time is long, the IGBT shutoff loss will be increased; while the pre off stage and main off stage time is short, it will be difficult to balance the IGBT voltage. When the pre on stage and main on stage time is long, the IGBT opening loss will increased; while the pre off stage and main off stage time is short, it will be difficult to balance the IGBT voltage.

The present invention provides an adaptive voltage control strategy based on series IGBT loss optimization, on the premise of series IGBT voltage balance, which increases switch speed, and reduces the IGBT switching loss by detecting the IGBT terminal voltage, rationally adjust the time of the pre off stage, the main off stage, pre opening stage and the main opening stage.

Compared with the prior art, the beneficial effects of the invention are:
1. When IGBT series, the voltage balance reliability is high;
2. When IGBT series, the switching loss is low;
3. The voltage stress is controllable when the switch on and off.

### BRIEF DESCRIPTION OF THE DRAWINGS

Figure 1 is the schematic diagram of IGBT reference voltage waveform of the present invention;
Figure 2 is the function block diagram of IGBT loss optimization control strategy in main on/off process.
Figure 3 is the function block diagram of IGBT loss optimization control strategy in pre-on/off process.
Figure 4: the schematic diagram of IGBT reference voltage waveform before adjustment at off stage;
Figure 5: the schematic diagram of IGBT reference voltage waveform after adjustment at off stage;
Figure 6: the schematic diagram of IGBT voltage waveform before adjustment at off stage;
Figure 7: the schematic diagram of IGBT voltage waveform after adjustment at off stage;
Figure 8: the schematic diagram of IGBT reference voltage waveform before adjustment at on stage;
Figure 9: the schematic diagram of IGBT reference voltage waveform after adjustment at on stage;
Figure 10: the schematic diagram of IGBT voltage waveform before adjustment at on stage;
Figure 11: the schematic diagram of IGBT voltage waveform after adjustment at on stage.

### DETAILED DESCRIPTION OF EMBODIMENTS

The detail of the embodiments is described as below incorporated with the figures by way of cross-reference for the present invention.

The reference voltage waveform is shown as figure 1, which mainly contains pre-off stage (t0-t1), main off stage (t1-t2), pre-on on stage (t3-t4) and main on stage (t4-t5). The control principle of pre-off stage and pre-on stage is the same, and so do main off stage and main on stage.

The principle diagram at main off and main on stage is shown in figure 2. Each IGBT of it is controlled independently by their own drive circuit, the control signals of the drive circuit of IGBT on valve arm are provided by the same valve base control unit.

The optimal control at the main off and main on stages contains adjustment 1 and adjustment 2:
Adjustment 1: Which detects IGBT terminal voltage; compares the dv/dt value of IGBT on/off with that of reference voltage provided by the valve base control unit, which is sending dv/dt decrease signal to the superior when the difference is smaller than the allowable value,and sending dv/dt increase signal to the higher level when the difference is greater than the allowable value. Valve base control unit detects all adjustment signals delivered by the drive units, when all the signals are to improve the dv/dt, the valve base control unit will improve the dv/dt of the reference voltage; when there is a signal to reduce dv/dt, the valve base control unit will reduce the dv/dt of the reference voltage. And the reference voltage adjusted will be delivered to each the drive unit.
Adjustment 2: Which detects IGBT terminal voltage; compares the dv/dt value of IGBT on/off with that of reference voltage provided by the valve base unit. When the dv/dt value of IGBT is more than that of reference voltage provided by the valve base unit, the dv/dt value of reference voltage is reduced; and when the dv/dt value of IGBT is less than that of reference voltage provided by the valve base unit, the dv/dt value of reference voltage is improved. And the reference voltage adjusted will be sent to the lower level for IGBT voltage balancing control.

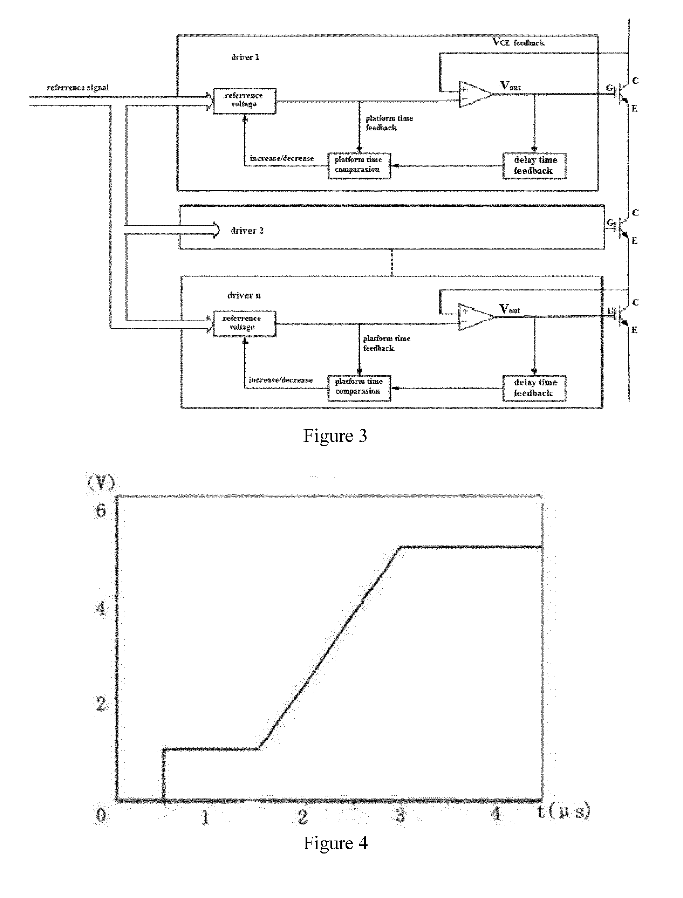

Pre-off stage (t0-t1) and pre-on stage (T3-T4) control principle block diagram is shown in figure 3. This part is realized by each drive unit separately, each IGBT is independent, which detects Vout voltage waveform in each drive unit, and determines the IGBT need delay time. The actual delay time of IGBT with the pre-on/off time given by the reference voltage is compared, when the actual delay time of IGBT is more than the pre-on/off time given by the reference voltage to increase the given time of the pre-on/off of the reference voltage.when the actual delay time of IGBT is less than the pre-on/off time given by the reference voltage to short the given time of the pre-on/off of the reference voltage..

The adaptive voltage control strategy based on loss optimization provided by the present invention optimizes pre-on/off stage and the main on/off stage, respectively , and reduces the IGBT switching loss with the premise of IGBT voltage balance. The pre-on/off stage adjustment and the main on/off stage adjustment are independent with each other.

According to the above control principle, the simulation results are shown below:

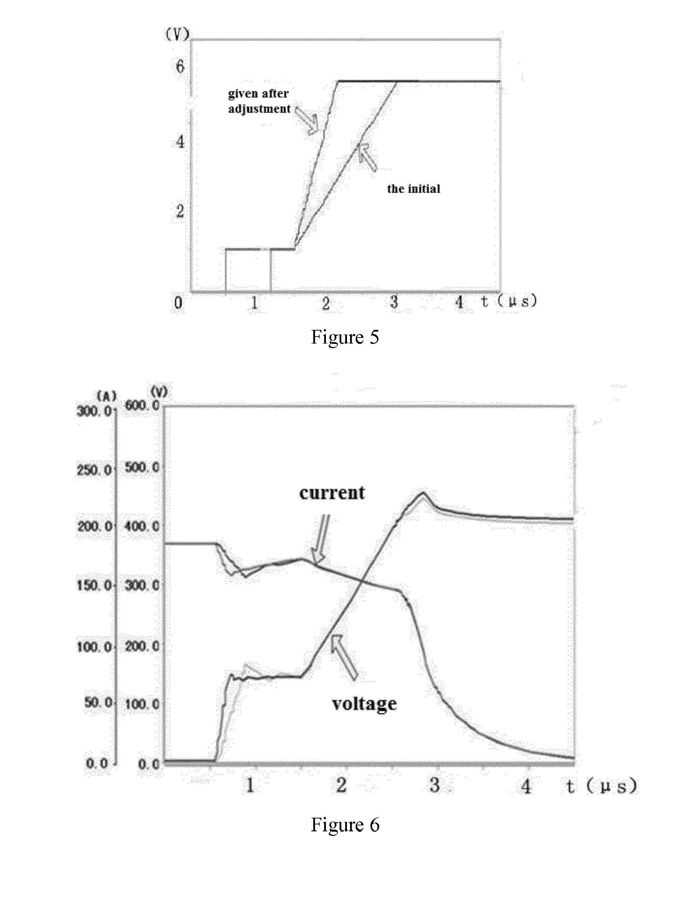

Figure 4 and figure 5 are the reference voltage waveform before and after adjustment at off stage;

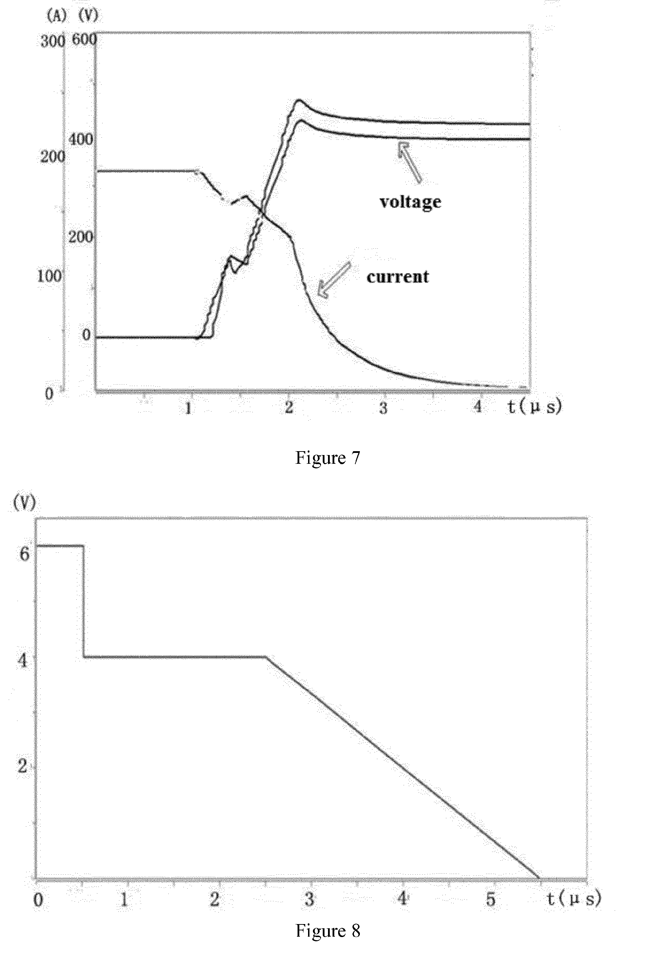

Figure 6 and figure 7 are the IGBT voltage waveform before and after adjustment at off stage. It is known that the IGBT shutdown speed is rapid and the switching loss is reduced to ideal value after the optimizing the IBGT pre and main shut down time.

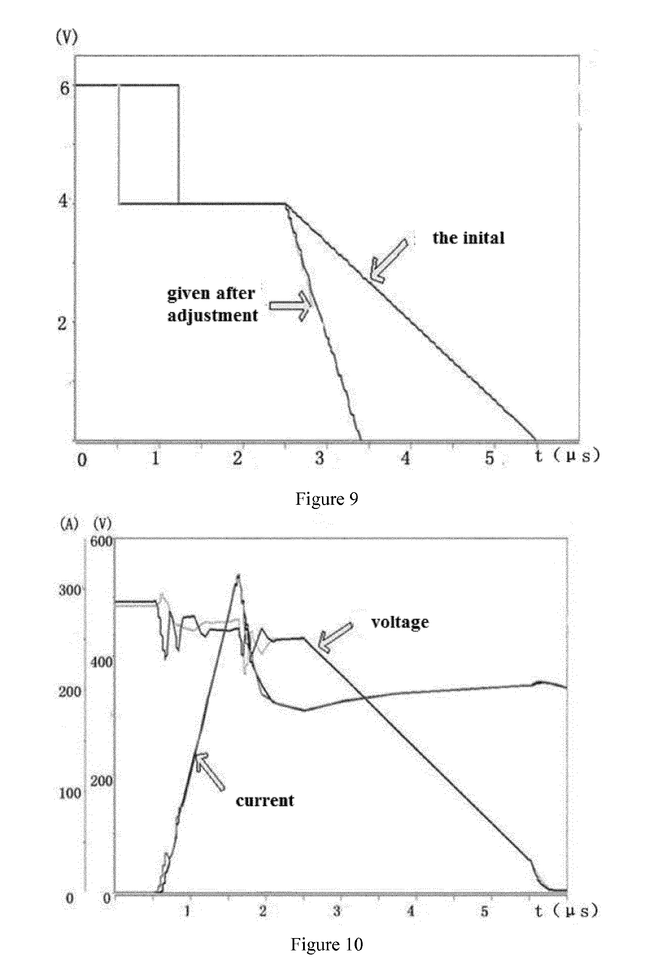

Figure 8 and figure 9 are the reference voltage waveform before and after adjustment at on stage;

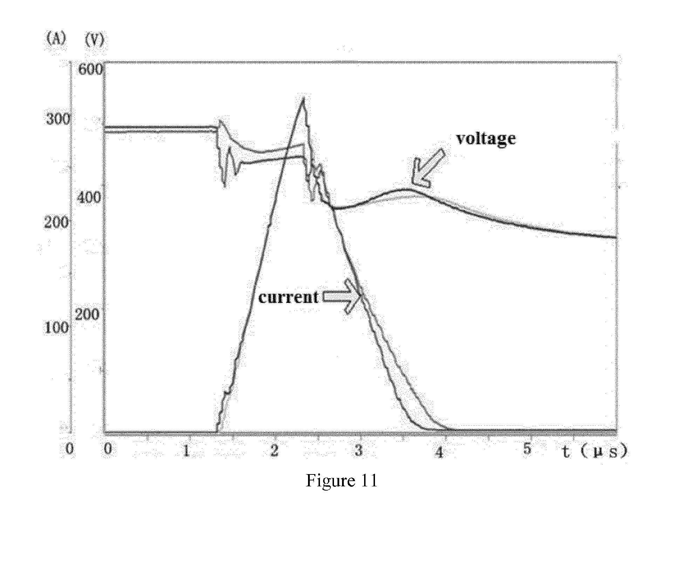

Figure 10 and figure 11 are the IGBT voltage waveform before and after adjustment at off stage. It is known that the IGBT turn on speed increases rapidly and the loss is reduced to ideal value after the optimizing the pre and main opening time.

Thus, although there have been described particular embodiments of the present invention of a new and useful adaptive voltage control method, it is not intended that such reference be construed as limitations upon the scope of this invention except as set forth in the following claims. Further, although there have been described certain operation steps used in the preferred embodiment, it is non intended that such steps be construed as limitations upon the scope of this invention except as set forth in the following claims.

## Claims

1. An adaptive voltage control method based on series IGBT loss optimization, is characterized that the method includes steps as below:
(1) Detecting IGBT terminal voltage;
(2) Adjusting the time of the main on/off stage;
(3) Adjusting the time of the per-on/off stage.

2. An adaptive voltage control method based on series IGBT loss optimization according to claim 1, is characterized that, wherein said main adjustment on/off stage includes main opening stage and main shutting stage; said pre-on/off stage includes opening pre adjustment stage and shutoff pre adjustment stage.

3. The method according to claim 2, is characterized that, in said main adjustment on/off stage, each IGBT is controlled independently by their own drive circuit; the control signals of the drive circuit of IGBT are provided by the same valve base control unit.

4. The method according to claim 1, is characterized that, said the adjust time of the pre-on/off stage in step (2) includes below two steps:
(2-1) Detecting the IGBT terminal voltage through said step (1), comparing the dv/dt value of IGBT on/off with that of reference voltage provided by the valve base unit, and judging the difference between them, and sending the increase or decrease signal of dv/dt to the higher level, and then valve base control unit adjusting dv/dt of the reference voltage according to the received signal from the drive unit;
(2-2) Detecting the IGBT terminal voltage through said step (1), comparing the dv/dt value of IGBT on/off with that of reference voltage provided by the valve base unit, and determining to increase or decrease the dv/dt, and sending the signal to the lower level to balance IGBT voltage.

5. The method according to claim 2, is characterized that, said adjusting the time of the pre-on/off stage in said step (3) is carried out at each drive unit, and each IGBT is independent separately, the drive unit detects the waveform of *Vout,* and compare the actual delay time of IGBT with the pre-on/off time given by the reference voltage to determine to increase or decrease the given time of the pre-on/off of the reference voltage.

6. The method according to claim 4-5, is characterized that, said adjustments of pre-on/off and main on/off stage are independent with each other.
